# EUROPEAN PATENT APPLICATION

(11) **EP 4 645 621 A1**
(43) Date of publication of application: **05.11.2025**
(21) Application number: 24173167.8
(22) Date of filing: 29.04.2024
(51) Int. Cl.: H02H 3/16, H02H 7/06, H02H 3/00

(54) **SYSTEM AND METHOD FOR AUTOMATIC CALIBRATION OF STATOR EARTH FAULT PROTECTION FOR GENERATOR**

(71) Applicant: Siemens Aktiengesellschaft, 80333 München (DE)
(72) Inventor: R, Manikandan, 609602 Karaikal, Puducherry (IN); RAJASEKARAN, Vijayaganesh, 560100 Bangalore (IN); SCHNEIDER, Sebastian, 90522 Oberasbach (DE)
(74) Representative: Patentanwaltskanzlei WILHELM & BECK

(57) **Abstract**

Disclosed is a system (200) and a method (400) for automatic calibration of stator earth fault protection for a generator. The system (200) comprises an Intelligent Electronic Device IED (202) configured to operate in a first calibration mode to connect with a grounding terminal (204) and a second calibration mode to connect with a digital potentiometer (206). The system (200) further comprises a processing unit (104) to obtain phase angle value and fault resistance value from the IED (202), by operating the IED (202) in the first calibration mode thereof; determine one or more of a correct phase angle value and a correct fault resistance value for the IED (202) based on deviation from respective expected value, utilizing linear regression algorithm(s); evaluate the determined values under the different resistance values, by operating the IED (202) in the second calibration mode thereof; and configure the IED (202) with corrected values if the evaluation for the stator earth fault protection succeeds.

## Description

The present invention pertains to the field of electrical generator protection systems. More specifically, the present invention relates to an automated system and method for calibrating stator earth fault protection in generators using machine learning techniques to enhance accuracy, reliability, and efficiency.

In power generation systems, generators are expensive and critical equipment. Proper protection mechanisms ensure the generator is safeguarded from faults, abnormal operating conditions, and potential damage. Generator protection plays vital role in maintaining power system stability and enabling the continuous operation. 100% stator earth fault protection is crucial for generators to detect and mitigate a specific type of fault that can have severe consequences if left unaddressed, ensure personnel safety, protect generator equipment, maintain power system stability, and comply with industry regulations. Neglecting to implement such protection measures can lead to safety hazards, equipment damage, instability in the power system, and non-compliance with regulatory requirements.

The current state of the art in generator protection involves the use of Intelligent Electronic Devices (lEDs) for the detection and mitigation of stator earth faults, which are critical for the safe and efficient operation of generators. These lEDs are calibrated manually to ensure they accurately detect faults and protect the generator from damage and power outages. Manual calibration involves adjusting settings based on empirical data, expert knowledge, and testing under various conditions. This approach is widely used across generating stations to maintain power system stability and ensure continuous operation.

However, manual calibration of stator earth fault protection systems has several issues. Manual calibration is a time-consuming, tedious, and complex activity that requires significant expertise and can take anywhere from four to eight hours to complete. The effectiveness of manual calibration heavily relies on the individual's expertise and experience, which can vary significantly. This can result in inaccurate pick-up current thresholds, time delays, or other parameters and can lead to false tripping, delayed fault detection, or failure to detect actual faults, compromising the effectiveness of the protection system. Manual calibration is not only laborious but also repetitive, demanding extensive efforts to accurately determine the compensation angle and ground resistance. This involves multiple instances of grounding short-circuiting to determine the precise compensation values, making the process time-consuming.

Further, given that stator earth faults often involve low fault currents, manual calibration without proper equipment and expertise may result in insufficient sensitivity of the protection system. This can prevent the detection of lower magnitude faults, increasing the risk of equipment damage, safety hazards, and potential system instability. Manual calibration may also lead to longer response times for stator earth fault protection. If the calibration settings are not optimized or if the manual adjustments are not precise, the time delay for tripping the generator may be longer than necessary. Delayed response times allow the fault to escalate, resulting in further damage to the generator and potential disruptions to the power system. It may also be noted that generator protection systems often involve multiple protective relays and devices that need to be coordinated for proper operation. Manual calibration may result in improper coordination between in-device settings and actual values.

Conventional solutions to these problems are limited. Existing techniques are constrained by their inability to adapt to real-time changes, the extensive time requirements for calibration, and the risk of human error. The manual process remains the standard practice, with all its associated drawbacks. This lack of automation in the calibration process underscores the need for a solution that can address the accuracy, time efficiency, and reliability concerns inherent in manual calibration. The present invention seeks to address these issues to significantly enhance the accuracy, reliability, and efficiency of the calibration process, reducing the risk of false tripping and power outages, minimizing human error, and allowing for real-time adaptation to changing conditions.

The object of the present invention is achieved by a system for automatic calibration of stator earth fault protection for a generator. The system comprises an Intelligent Electronic Device (IED) configured to operate in a first calibration mode and a second calibration mode. The system further comprises a grounding terminal adapted to connect with the lED when operated in the first calibration mode thereof. The grounding terminal is configured to provide a controlled path from the lED to ground. The system further comprises a digital potentiometer adapted to connect with the lED when operated in the second calibration mode thereof. The digital potentiometer is configured to simulate a range of earth fault conditions for the lED under different resistance values. The system further comprises a processing unit. The processing unit is configured to obtain phase angle value and fault resistance value from the IED, by operating the lED in the first calibration mode thereof. The processing unit is further configured to determine one or more of a correct phase angle value and a correct fault resistance value for the lED based on deviation of the phase angle value and the fault resistance value, as obtained, from respective expected value, utilizing linear regression algorithm(s). The processing unit is further configured to evaluate the one or more of the correct phase angle value and the correct fault resistance value, as determined, for the lED for the stator earth fault protection under the different resistance values, by operating the lED in the second calibration mode thereof. The processing unit is further configured to configure the lED with the one or more of the correct phase angle value and the correct fault resistance value if the evaluation for the stator earth fault protection succeeds.

In one or more embodiments, the processing unit is configured to close a contact between the grounding terminal and the lED to operate the lED in the first calibration mode thereof.

In one or more embodiments, the processing unit is configured to open the contact between the grounding terminal and the IED, and close the contact between the digital potentiometer and the lED to operate the lED in the second calibration mode thereof.

In one or more embodiments, the processing unit is further configured to determine at least one of a pickup value and a trip value for the lED based on the configuration thereof.

In one or more embodiments, the processing unit is further configured to initiate calibration of the lED in response to any one of the phase angle value and the fault resistance value deviating from the respective expected value.

In one or more embodiments, the automatic calibration of the stator earth fault protection for the generator is implemented as part of a standalone application or incorporated into a digital twin of the generator.

In one or more embodiments, the system further comprises a communication module configured to communicate calibration results and configuration updates to a user.

In one or more embodiments, the linear regression algorithm(s), utilized by the processing unit, are configured to adjust weighting factors based on historical calibration data of the lED in detecting stator earth faults, for determining the one or more of the correct phase angle value and the correct fault resistance value.

The object of the present invention is also achieved by a method for automatic calibration of stator earth fault protection for a generator. The method comprises operating an Intelligent Electronic Device (IED) in a first calibration mode by connecting the lED with a grounding terminal. The grounding terminal is configured to provide a controlled path from the lED to ground. The method further comprises obtaining phase angle value and fault resistance value from the lED, by operating the lED in the first calibration mode thereof. The method further comprises determining one or more of a correct phase angle value and a correct fault resistance value for the lED based on deviation of the phase angle value and the fault resistance value, as obtained, from respective expected value, using linear regression algorithm(s). The method further comprises operating the lED in a second calibration mode by connecting the lED with a digital potentiometer. The method further comprises simulating a range of earth fault conditions for the lED under different resistance values using the digital potentiometer. The method further comprises evaluating the one or more of the correct phase angle value and the correct fault resistance value, as determined, for the lED for the stator earth fault protection under the different resistance values, by operating the lED in the second calibration mode thereof. The method further comprises configuring the lED with the one or more of the correct phase angle value and the correct fault resistance value if the evaluation for the stator earth fault protection succeeds.

The object of the present invention is further achieved by a computer program product, having machine-readable instructions stored therein, that when executed by the one or more processing units, cause the one or more processing units to perform aforementioned method steps.

Still, other aspects, features, and advantages of the invention are readily apparent from the following detailed description, simply by illustrating a number of particular embodiments and implementations, including the best mode contemplated for carrying out the invention. The invention is also capable of other and different embodiments, and its several details may be modified in various obvious respects, all without departing from the scope of the invention. Accordingly, the drawings and description are to be regarded as illustrative in nature, and not as restrictive.

A more complete appreciation of the present invention and many of the attendant aspects thereof will be readily obtained as the same becomes better understood by reference to the following description when considered in connection with the accompanying drawings:
- FIG 1: is a block diagram representation of a computing system for automatic calibration of stator earth fault protection for a generator, in accordance with one or more embodiments of the present disclosure;
- FIG 2: is a circuit diagram of a system for the automatic calibration of the stator earth fault protection for the generator, in accordance with one or more embodiments of the present invention;
- FIG 3: is an architecture of an automatic calibration function for automatic calibration of stator earth fault protection for the generator, in accordance with one or more embodiments of the present invention;
- FIG 4: is a flowchart of a method for the automatic calibration function for the automatic calibration of the stator earth fault protection for the generator, in accordance with one or more embodiments of the present invention; and
- FIG 5: is a flowchart of the automatic calibration function, in accordance with one or more embodiments of the present invention.

Various embodiments are described with reference to the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

Examples of a method, a system, and a computer-program product for automatic calibration of stator earth fault protection for a generator are disclosed herein. In the following description, for the purposes of explanation, numerous specific details are set forth in order to provide a thorough understanding of the embodiments of the invention. It is apparent, however, to one skilled in the art that the embodiments of the invention may be practiced without these specific details or with an equivalent arrangement. In other instances, well-known structures and devices are shown in block diagram form in order to avoid unnecessarily obscuring the embodiments of the invention.

For purposes of the present invention, stator earth fault is an electrical fault condition in the stator winding of a generator or motor, where insulation failure allows current to flow to the earth, potentially causing damage or operational issues. It can occur due to insulation breakdown from aging, thermal stress, mechanical vibration, or environmental conditions. Calibration is needed to ensure the protective systems accurately detect such faults, preventing further damage and maintaining system reliability. Proper calibration helps in setting the sensitivity of detection systems to balance between avoiding false alarms and ensuring real faults are detected and addressed promptly.

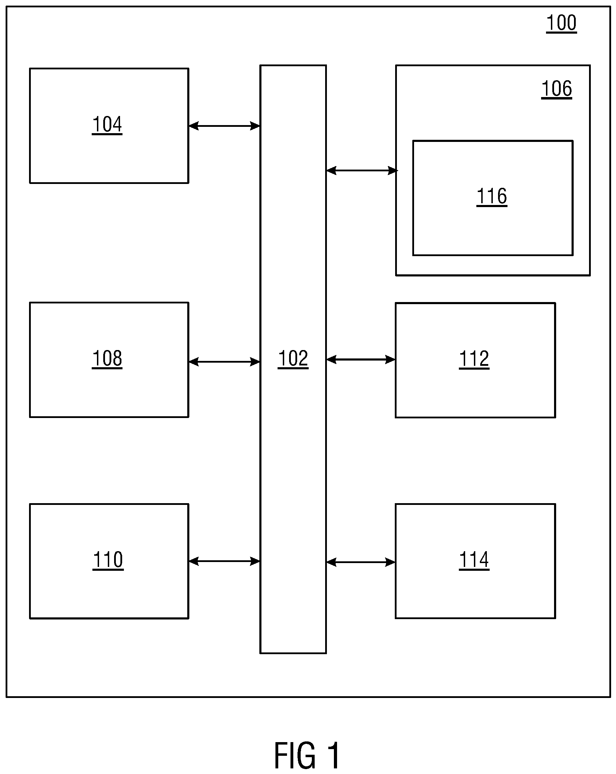

Referring to FIG 1, illustrated is a block diagram of a computing arrangement 100 for automatic calibration of stator earth fault protection for a generator, in accordance with one or more embodiments of the present invention. It may be appreciated that the computing arrangement 100 described herein may be implemented in various forms of hardware, software, firmware, special purpose processors, or a combination thereof. One or more of the present embodiments may take a form of a computer program product comprising program modules accessible from computer-usable or computer-readable medium storing program code for use by or in connection with one or more computers, processors, or instruction execution system. For the purpose of this description, a computer-usable or computer-readable medium may be any apparatus that may contain, store, communicate, propagate, or transport the program for use by or in connection with the instruction execution system, apparatus, or device. The medium may be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and digital versatile disc (DVD). Both processors and program code for implementing each aspect of the technology may be centralized or distributed (or a combination thereof) as known to those skilled in the art.

In an example, the computing arrangement 100 may be embodied as a computer-program product programmed for the automatic calibration of stator earth fault protection for the generator. The computing arrangement 100 may be incorporated in one or more physical packages (e.g., chips). By way of example, a physical package includes an arrangement of one or more materials, components, and/or wires on a structural assembly (e.g., a baseboard) to provide one or more characteristics such as physical strength, conservation of size, and/or limitation of electrical interaction. It is contemplated that in certain embodiments the computing device may be implemented in a single chip. As illustrated, the computing arrangement 100 includes a communication mechanism such as a bus 102 for passing information among the components of the computing arrangement 100. The computing arrangement 100 includes one or more processing units 104 and one or more memory units 106. Herein, the memory unit 106 is communicatively coupled to the processing unit 104. In an example, the memory unit 106 may be embodied as a computer readable medium on which program code sections of a computer program are saved, the program code sections being loadable into and/or executable in a system to make the computing arrangement 100 execute the steps for performing the said purpose.

Generally, as used herein, the term "processing unit" refers to a computational element that is operable to respond to and processes instructions that drive the computing arrangement 100. Optionally, the processing unit includes, but is not limited to, a microprocessor, a microcontroller, a complex instruction set computing (CISC) microprocessor, a reduced instruction set (RISC) microprocessor, a very long instruction word (VLIW) microprocessor, or any other type of processing circuit. Furthermore, the term "processing unit" may refer to one or more individual processors, processing devices and various elements associated with a processing device that may be shared by other processing devices. Additionally, the one or more individual processors, processing devices and elements are arranged in various architectures for responding to and processing the instructions that drive the computing arrangement 100.

Herein, the memory unit 106 may be volatile memory and/or non-volatile memory. The memory unit 106 may be coupled for communication with the processing unit 104. The processing unit 104 may execute instructions and/or code stored in the memory unit 106. A variety of computer-readable storage media may be stored in and accessed from the memory unit 106. The memory unit 106 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

In particular, the processing unit 104 has connectivity to the bus 102 to execute instructions and process information stored in the memory unit 106. The processing unit 104 may include one or more processing cores with each core configured to perform independently. A multi-core processor enables multiprocessing within a single physical package. Examples of a multi-core processor include two, four, eight, or greater numbers of processing cores. Alternatively, or in addition, the processing unit 104 may include one or more microprocessors configured in tandem via the bus 102 to enable independent execution of instructions, pipelining, and multithreading. The processing unit 104 may also be accompanied with one or more specialized components to perform certain processing functions and tasks such as one or more digital signal processors (DSP), and/or one or more application-specific integrated circuits (ASIC).

Other specialized components to aid in performing the inventive functions described herein include one or more field programmable gate arrays (FPGA) (not shown), one or more controllers (not shown), or one or more other special-purpose computer chips.

The computing arrangement 100 may further include an interface 108, such as a communication module (with the said terms being interchangeably used) which may enable the computing arrangement 100 to communicate with other systems for receiving and transmitting information. The communication module 108 may include a medium (e.g., a communication channel) through which the computing arrangement 100 communicates with other system. Examples of the communication module 108 may include, but are not limited to, a communication channel in a computer cluster, a Local Area Communication channel (LAN), a cellular communication channel, a wireless sensor communication channel (WSN), a cloud communication channel, a Metropolitan Area Communication channel (MAN), and/or the Internet. Optionally, the communication module 108 may include one or more of a wired connection, a wireless network, cellular networks such as 1G, 3G, 4G, 5G mobile networks, and a Zigbee connection.

The computing arrangement 100 also includes a database 110. As used herein, the database 110 is an organized collection of structured data, typically stored in a computer system and designed to be easily accessed, managed, and updated. The database 110 may be in form of a central repository of information that may be queried, analysed, and processed to support various applications and business processes. In the computing arrangement 100, the database 110 provides mechanisms for storing, retrieving, updating, and deleting data, and typically includes features such as data validation, security, backup and recovery, and data modelling.

The computing arrangement 100 further includes an input device 112 and an output device 114. The input device 112 may take various forms depending on the specific application of the computing arrangement 100. In an example, the input device 112 may include one or more of a keyboard, a mouse, a touchscreen display, a microphone, a camera, or any other hardware component that enables the user to interact with the computing arrangement 100. Further, the output device 114 may be in the form of a display, a printer, a communication channel, or the like, without any limitations.

In the present computing arrangement 100, the processing unit 104 and accompanying components have connectivity to the memory unit 106 via the bus 102. The memory unit 106 includes both dynamic memory (e.g., RAM, magnetic disk, writable optical disk, etc.) and static memory (e.g., ROM, CD-ROM, etc.) for storing executable instructions that when executed perform the method steps described herein for automatic calibration of stator earth fault protection for the generator. In particular, the memory unit 106 includes a calibration module 116 to perform steps for the said purpose.

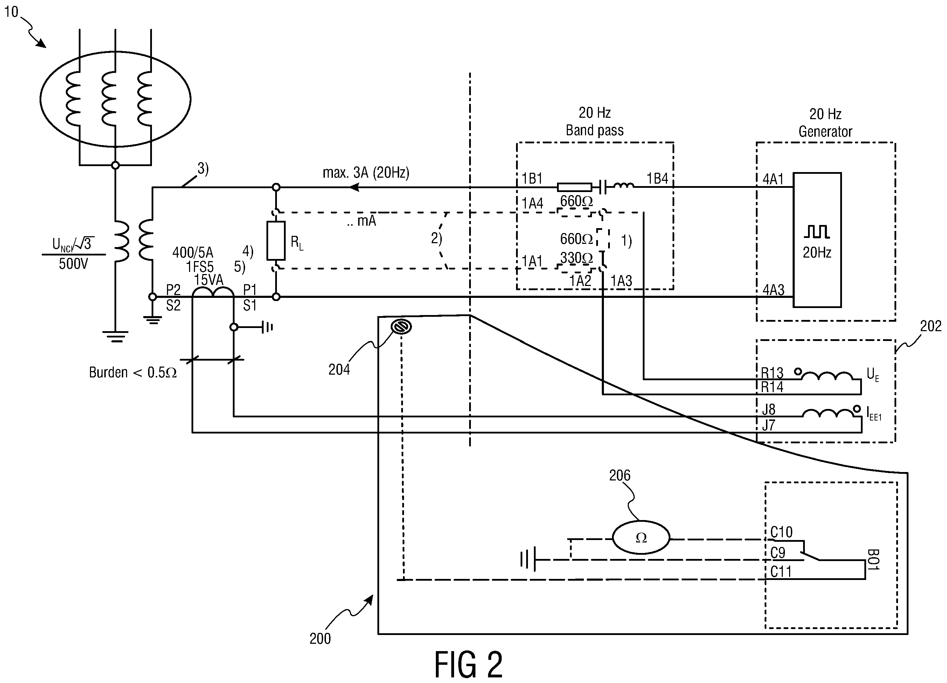

Referring to FIG 2, illustrated is an exemplary circuit diagram of a system 200 (as represented by reference numeral 200) for automatic calibration of stator earth fault protection for the generator, as part of a larger stator earth fault protection system 10, in accordance with one or more embodiments of the present invention. The system 200 of the present invention is designed to automate and refine the calibration process, ensuring optimal operation of the stator earth fault protection system 10. The system 200 introduces a methodical approach for such calibration utilizing machine learning algorithms. The conventional method of manual calibration, reliant on the expertise and experience of operators, presents numerous challenges, including the risk of inaccurate settings, the time-intensive nature of the calibration process, and the potential for reduced sensitivity and increased response times of the protection system. The system 200 for automatic calibration aims to overcome these challenges by providing a structured and automated calibration process that enhances the accuracy, reliability, and efficiency of stator earth fault protection.

As illustrated, the system 200 includes an Intelligent Electronic Device (IED) 202. The lED 202 is a microprocessor-based controller of the system 200, such as the generator, which is configured to collect, analyse, and act on data. The lED 202 is capable of performing a wide range of functions including protection, control, monitoring, and metering. The lED 202 is configured to communicate with other devices in the system 200 and is used in substations and various parts of the electrical distribution network. The system 200 also includes a grounding terminal 204. The grounding terminal 204 is adapted to connect with the lED 202. Specifically, the grounding terminal 204 is configured to provide a controlled path from the lED 202 to ground. The function of the grounding terminal 204 is to simulate a real-world grounding scenario, enabling the lED 202 to assess and calibrate the stator earth fault protection system under conditions that closely mimic actual operational environments. By providing a controlled grounding path, the grounding terminal 204 ensures that the lED 202 can accurately determine the necessary adjustments to the protection settings, thereby enhancing the precision of the stator earth fault protection. The system 200 further includes a digital potentiometer 206. The digital potentiometer 206 is configured to simulate a range of earth fault conditions for the lED 202 under different resistance values. The inclusion of the digital potentiometer 206 allows for a high degree of precision in simulating fault conditions, as it can accurately replicate varying degrees of earth faults by adjusting its resistance. This simulation allows for an assessment of response of the lED 202 to diverse fault scenarios, for ensuring the effectiveness and reliability of the stator earth fault protection system 10.

In the present system 200, the lED 202 is configured to operate in a first calibration mode and a second calibration mode. Herein, the grounding terminal 204 is adapted to connect with the lED 202 when operated in the first calibration mode thereof. That is, when the lED 202 operates in the first calibration mode, the grounding terminal 204 is engaged to establish a direct and controlled path from the lED 202 to the ground. The first calibration mode of the lED 202 establishes a base calibration setting by connecting to the grounding terminal 204, thus providing a controlled path from the lED 202 to the ground. By providing a controlled grounding path, the grounding terminal 204 ensures that the lED 202 can accurately determine the necessary adjustments to the protection settings, thereby enhancing the precision of the stator earth fault protection. The first calibration mode allows for the initial acquisition of phase angle values and fault resistance values, which are key parameters in the calibration of stator earth fault protection for the generator. These initial values serve as a benchmark for assessing the accuracy and effectiveness of the stator earth fault protection system 10.

Further, the digital potentiometer 206 is adapted to connect with the lED 202 when operated in the second calibration mode thereof. In the second calibration mode, the lED 202 connects with the digital potentiometer 206, diverging from the grounding terminal connection utilized in the first calibration mode. The digital potentiometer 206 in this mode simulates a range of earth fault conditions by altering resistance values, thereby providing a testing environment for the lED 202. This simulation allows for evaluating the stator earth fault protection system 10 under varying fault conditions and for fine-tuning settings of the lED 202 to ensure optimal performance under diverse operational scenarios. The digital potentiometer 206 facilitates a dynamic and flexible calibration process, where the settings of the lED 202 can be fine-tuned based on the simulated fault conditions, ensuring optimal protection for the generator. The digital potentiometer 206 provides a controlled and measurable means to test the calibration adjustments made in the first calibration mode. This testing ensures that the adjustments are effective across a range of fault conditions, further enhancing the reliability and accuracy of the stator earth fault protection.

The system 200 further implements the processing unit 104 for performing various functions. This includes processing data, managing tasks, and ensuring efficient communication between various components of the system 200, thereby facilitating its overall functionality and performance. More specifically, the processing unit 104 within the system 200 is integral for orchestrating various operational and analytical tasks. The processing unit 104 interprets data from multiple sources, executes algorithms to process this information, and coordinates the activities of other components to ensure cohesive functionality. The processing unit 104 is configured for making real-time decisions based on the processed data, optimizing performance, and facilitating adaptive responses to changing conditions or inputs.

The processing unit 104 is configured to obtain phase angle value and fault resistance value from the lED 202, by operating the lED 202 in the first calibration mode thereof. As discussed, the first calibration mode is designated for initial data acquisition in which the lED 202, in conjunction with the grounding terminal 204, establishes a controlled path to ground, simulating a stator earth fault condition. The processing unit 104, during this phase, interfaces with the lED 202 to extract the phase angle value and the fault resistance value, both of which are important for the calibration process. The phase angle value is indicative of the angular difference between the current and voltage at the point of fault, which helps in identifying and diagnosing the nature and severity of stator earth faults. Similarly, the fault resistance value provides details about the resistance encountered by the fault current, providing valuable information on characteristics of the fault and the effectiveness of the grounding path. By operating the lED 202 in the first calibration mode, the processing unit 104 ensures that these values are obtained under controlled conditions that closely mimic actual fault scenarios. This approach allows for a more accurate and reliable calibration process, as the values obtained serve as a dataset upon which further calibration adjustments and evaluations are based.

In the present embodiments, the processing unit 104 is configured to close a contact between the grounding terminal 204 and the lED 202 to operate the lED 202 in the first calibration mode thereof. That is, the processing unit 104 within the system 200 is specifically configured to initiate the first calibration mode of the lED 202 by closing a contact between the grounding terminal 204 and the lED 202. This action establishes a direct electrical connection between the lED 202 and the grounding terminal 204, enabling the lED 202 to simulate an earth fault condition by providing a controlled path to ground. This connection allows the lED 202 to measure the phase angle values and the fault resistance values under conditions that closely resemble actual earth fault scenarios.

The processing unit 104 is further configured to determine one or more of a correct phase angle value and a correct fault resistance value for the lED 202 based on deviation of the phase angle value and the fault resistance value, as obtained, from respective expected value, utilizing linear regression algorithm(s). In particular, the processing unit 104 in the system 200 possesses the capability to refine the calibration process by determining the correct phase angle value and the correct fault resistance value for the lED 202. This determination is based on analysing the deviations of the initially obtained phase angle value and fault resistance value from their expected values. The processing unit 104 employs linear regression algorithms for this purpose, which are used for identifying patterns in data and predicting outcomes based on observed trends. For this purpose, when the lED 202 is operated in the first calibration mode, and the necessary values are obtained via the closed contact with the grounding terminal 204, these values are then analysed by the processing unit 104. The linear regression algorithms assess how the obtained values deviate from what is expected under normal operating conditions. This deviation indicates the extent of adjustment needed to align the lED 202 with the actual operating environment of the generator, ensuring the stator earth fault protection is accurately tuned.

In an embodiment, the linear regression algorithm(s), utilized by the processing unit 104, are configured to adjust weighting factors based on historical calibration data of the lED 202 in detecting stator earth faults, for determining the one or more of the correct phase angle value and the correct fault resistance value. It may be appreciated that the historical calibration data provides information regarding past calibration settings, fault detection instances, and the corresponding operational conditions of the lED 202, serving as a valuable reference point for the calibration process. By analysing this historical calibration data, the linear regression algorithms can identify patterns and trends that are indicative of behaviour of the lED 202 and its interaction with varying fault conditions. This analysis allows the algorithms to determine the 'weight' of different factors that influence the accuracy of the phase angle value and the fault resistance value measured by the lED 202. For instance, certain operational conditions may consistently lead to specific deviations in the fault resistance value, highlighting the need to adjust the weighting factor associated with this parameter in the calibration model. This ensures that the calibration of the lED 202 dynamically evolves based on operational insights, leading to continuous improvement in the detection and mitigation of stator earth faults, thereby improving the reliability and effectiveness of stator earth fault protection.

The processing unit 104 is further configured to evaluate the one or more of the correct phase angle value and the correct fault resistance value, as determined, for the lED 202 for the stator earth fault protection under the different resistance values, by operating the lED 202 in the second calibration mode thereof. As discussed, in the second calibration mode, the digital potentiometer 206 is utilized to create a range of earth fault conditions by varying the resistance values. This allows the processing unit 104 to assess how well the lED 202, with its newly calibrated settings for phase angle and fault resistance, performs under these varied conditions. The evaluation process involves comparing response of the lED 202 to these simulated faults against expected outcomes based on the calibrated settings. This step verifies the efficacy of the calibration adjustments made based on the initial data obtained in the first calibration mode and refined through linear regression algorithms. By testing the lED 202 under different simulated resistance values, the processing unit 104 ensures that the stator earth fault protection is reliable across a spectrum of fault scenarios.

In the present embodiments, the processing unit 104 is configured to open the contact between the grounding terminal 204 and the lED 202, and close the contact between the digital potentiometer 206 and the lED 202 to operate the lED 202 in the second calibration mode thereof. That is, the processing unit 104 is configured to transition the lED 202 from the first to the second calibration mode through specific operations involving the grounding terminal 204 and the digital potentiometer 206. To facilitate this transition, the processing unit 104 first opens the contact between the grounding terminal 204 and the lED 202, effectively disconnecting the direct grounding path established during the first calibration mode. Following the disconnection from the grounding terminal 204, the processing unit 104 proceeds to close the contact between the digital potentiometer 206 and the lED 202 to initiate the second calibration mode. This operational sequence managed by the processing unit 104 ensures proper transition between the two calibration modes, facilitating the calibration process.

The processing unit 104 is further configured to configure the lED 202 with the one or more of the correct phase angle value and the correct fault resistance value if the evaluation for the stator earth fault protection succeeds. The processing unit 104 finalizes the calibration process by configuring the lED 202 with the determined correct phase angle value and the correct fault resistance value. This configuration step is contingent upon the successful evaluation of the stator earth fault protection under the simulated fault conditions created during the second calibration mode. The evaluation phase, facilitated by the digital potentiometer 206, allows the processing unit 104 to assess performance of the lED 202 across a spectrum of simulated earth fault scenarios by varying resistance values. Upon achieving satisfactory results from this evaluation, indicating that the responses of the lED 202 align with the expected outcomes based on the newly calibrated settings, the processing unit 104 proceeds to implement these settings into the lED 202. This involves updating the lED 202 with the correct phase angle value and the correct fault resistance value, thereby optimizing its capability to detect and mitigate stator earth faults accurately. This, in turn, ensures that the lED 202 is equipped with the most reliable parameters for stator earth fault detection, contributing significantly to the safety and efficiency of generator operations within the power systems.

In some embodiments, the processing unit 104 is further configured to determine at least one of a pickup value and a trip value for the lED 202 based on the configuration thereof. This determination is an extension of the calibration process, where the processing unit 104 utilizes the calibrated phase angle value and fault resistance value to establish the thresholds at which the lED 202 initiates protective actions. Herein, the pickup value refers to the minimum fault current or condition at which the protection system 10 is designed to activate or "pick up" a signal indicating a fault condition. By using the digital potentiometer 206 to simulate various resistance levels, the system 200 can determine the lowest level of fault that can be reliably detected, ensuring that the protection system 10 is sensitive enough to real fault conditions. Similarly, the trip value is the point at which the protection system 10 decides that the fault condition is significant enough to warrant a protective action, such as isolating the affected part of the protection system 10. The variable resistance provided by the digital potentiometer 206 allows the system 200 to test at what fault severity the lED 202 should command a trip action, ensuring that the system 200 responds appropriately to actual fault conditions. By configuring the lED 202 to have precise pickup and trip values, the processing unit 104 ensures that the protective actions are initiated at the appropriate moments, enhancing the reliability and safety of the protection scheme.

Further, in an embodiment, the processing unit 104 is further configured to initiate calibration of the lED 202 in response to any one of the phase angle value and the fault resistance value deviating from the respective expected value. Herein, the processing unit 104 within the system 200 is designed to initiate the calibration process for the lED 202 proactively. This initiation is triggered in response to the detection of deviations in operational parameters, specifically the phase angle value or the fault resistance value, from their respective expected norms. Specifically, upon detecting that either the phase angle value or the fault resistance value has deviated from its expected range, the processing unit 104 automatically triggers the calibration sequence for the lED 202. The ensures that the calibration of the lED 202 is responsive to real-time changes in the operational environment of the generator. Thereby, the system 200 ensures that the lED 202 is continuously operating with the most current and optimized settings.

In embodiments of the present invention, the automatic calibration of the stator earth fault protection for the generator is implemented as part of a standalone application or incorporated into a digital twin of the generator. That is, the present system 200 offers versatility in its deployment, as it can be implemented either as part of the standalone application or integrated within the digital twin of the generator. This flexibility allows for the system 200 to be tailored to specific operational needs, enhancing its applicability across different generator systems and operational frameworks. When implemented as the standalone application, the system 200 functions as a dedicated calibration tool, independently operating to adjust and optimize the settings of the lED 202 for stator earth fault protection. Alternatively, or additionally, incorporating the system 200 into the digital twin of the generator expands its functionality and integration capabilities. A digital twin is a virtual model that mirrors the physical generator in real-time, providing a platform for monitoring, analysing, and simulating generator operations. By integrating the system 200 within this digital twin, the calibration process benefits from the extensive data and analytical capabilities of the digital twin environment.

In some embodiments, the system 200 further implements the communication module 108 (from the computing arrangement 100). to communicate calibration results and configuration updates to a user. The communication module 108 operates by compiling and sending detailed information about the calibration process, which may include, but not limited to, the corrected phase angle values and the fault resistance values determined during the calibration, any adjustments made to the pickup and trip values of the lED 202, and a summary of the calibration evaluation results under different simulated fault conditions. By providing this data, the communication module 108 allows users to understand the modifications made to settings of the lED 202 and the implications of these changes for stator earth fault protection. Thereby, the communication module 108 ensures that users are kept informed about the status and outcome of the calibration process, enabling informed decision-making.

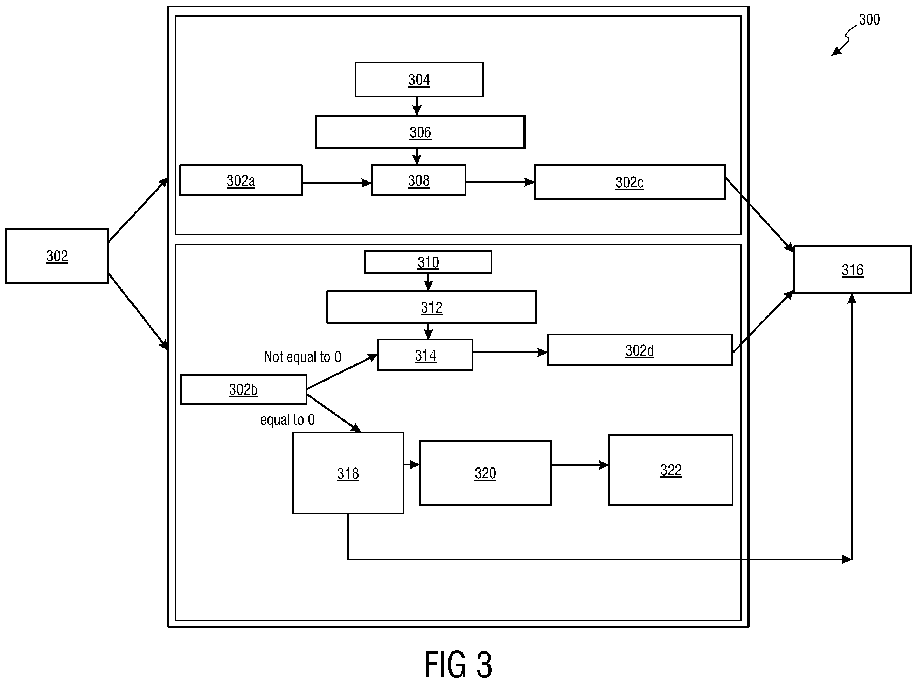

Referring now to FIG 3, illustrated is an architecture of an automatic calibration function (as represented by reference numeral 300) for automatic calibration of stator earth fault protection for the generator, in accordance with one or more embodiments of the present invention. The automatic calibration function 300 includes a sequence of operations. The automatic calibration function 300 starts with the prerequisite that the lED (as represented by block 302) is set to the calibration mode. Specifically, the lED 302 operates in two calibration modes and provides measured values of phase angle (Φ20 / 2311:310) (as represented by block 302a) and fault resistance (Rf / 2311:309) (as represented by block 302b).

In the workflow of the automatic calibration function, at block 304, a collection of data related to compensation angle and compensation resistance values recorded during manual calibration processes serves as a training dataset for the linear regression algorithm. At block 306, a linear regression algorithm, which is a machine learning algorithm, is used to determine the correction angle and resistance values for accurate calibration based on the training dataset. At block 308, a hypothesis represents the final output of the linear regression algorithm, which provides the corrected phase angle value (2311:15) (as represented by block 302c) based on the measured phase angle value from the lED 302.

Further, similar to block 304, at block 310, a training dataset is used for calibrating the fault resistance value 302b. At block 312, another instance of the linear regression algorithm is implemented, specifically used for determining the corrected fault resistance value. At block 314, a hypothesis generates the corrected fault resistance value (2311:309 Rf) (as represented by block 302d) based on the measured Rf value from the lED and output of the linear regression algorithm. Furthermore, at block 316, configuration tools are used to feed the corrected phase angle and fault resistance values back into the lED for calibration. A decision is implemented to check if the corrected fault resistance value obtained from the linear regression algorithm is equal to 0.

If the corrected fault resistance value is equal to 0, at block 318 (function 1), a digital potentiometer (POT) controller is initiated to set the POT value for further testing and evaluation. At block 320, the process of checking the calibrated values by simulating various earth fault conditions is implemented using different resistance values with the digital potentiometer (function 2). At block 322, based on the simulated earth fault conditions with different resistance values, the pick-up value and the trip value are evaluated for the stator earth fault protection using the digital potentiometer (function 3).

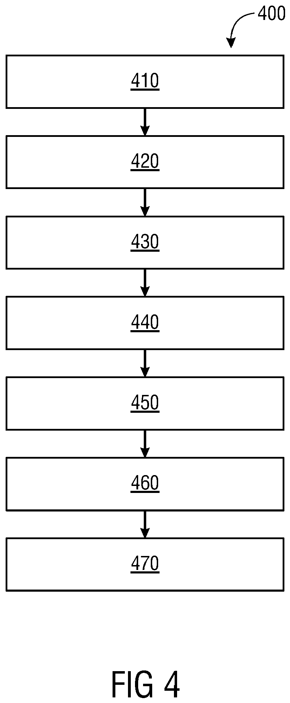

Referring to FIG 4, illustrated is a flowchart of a method (as represented by reference numeral 400) for automatic calibration function for automatic calibration of stator earth fault protection for the generator, in accordance with one or more embodiments of the present invention. Various steps of the method 400 (as described hereinafter), which may be executed in the computing arrangement 100, or specifically in the processing unit 104 of the computing arrangement 100 are described. It may be appreciated that although the method 400 is illustrated and described as a sequence of steps, it may be contemplated that various embodiments of the method 400 may be performed in any order or different combinations, and need not include all of the illustrated steps.

At step 410, the method 400 includes operating an Intelligent Electronic Device (IED) in a first calibration mode by connecting the lED with a grounding terminal, the grounding terminal configured to provide a controlled path from the lED to ground. That is, the process begins by setting the lED to operate in the first calibration mode, which is activated by establishing a connection between the lED and the grounding terminal. The first calibration mode is specifically designed to create a controlled path from the lED to the ground, to simulate the earthing conditions which the lED would encounter during an actual stator earth fault.

At step 420, the method 400 includes obtaining phase angle value and fault resistance value from the IED, by operating the lED in the first calibration mode thereof. That is, while in the first calibration mode, the method 400 involves the acquisition of key parameters from the IED, including the phase angle value and the fault resistance value. These values helps in determining the calibration state of the lED with respect to stator earth faults. The obtained phase angle value and fault resistance value are compared against their expected values, which represent the ideal conditions when no fault is present.

At step 430, the method 400 includes determining one or more of a correct phase angle value and a correct fault resistance value for the lED based on deviation of the phase angle value and the fault resistance value, as obtained, from respective expected value, using linear regression algorithm(s). That is, if there is any discrepancy between the obtained values and the expected values, the method 400 proceeds to utilize linear regression algorithm(s) to determine the correct phase angle value and the correct fault resistance value. Herein, the linear regression algorithms analyse the deviations and predict the correct values needed to calibrate the lED accurately.

At step 440, the method 400 includes operating the lED in a second calibration mode by connecting the lED with a digital potentiometer. This second calibration mode is characterized by the connection of the lED to the digital potentiometer. The digital potentiometer is configured to emulate various earth fault scenarios that the lED might encounter, which is achieved by manipulating the resistance values encountered by the lED.

At step 450, the method 400 includes simulating a range of earth fault conditions for the lED under different resistance values using the digital potentiometer. That is, once the lED is connected to the digital potentiometer and operating in the second calibration mode, the method 400 proceeds with the simulation of different earth fault conditions. The digital potentiometer adjusts resistance values systematically, which enables the lED to experience these conditions as if these are faults occurring within the generator.

At step 460, the method 400 includes evaluating the one or more of the correct phase angle value and the correct fault resistance value, as determined, for the lED for the stator earth fault protection under the different resistance values, by operating the lED in the second calibration mode thereof. That is, the method 400 then involves evaluating the determined correct phase angle value and fault resistance value. This evaluation is conducted by observing performance of the lED in the second calibration mode as it responds to the simulated fault conditions presented by the digital potentiometer.

At step 470, the method 400 includes configuring the lED with the one or more of the correct phase angle value and the correct fault resistance value if the evaluation for the stator earth fault protection succeeds. That is, if the evaluation confirms that responses of the lED to the simulated fault conditions are within acceptable parameters, the method 400 concludes with configuring the lED with the verified correct phase angle value and fault resistance value. This configuration ensures that the stator earth fault protection is finely tuned and calibrated to respond appropriately under actual fault conditions.

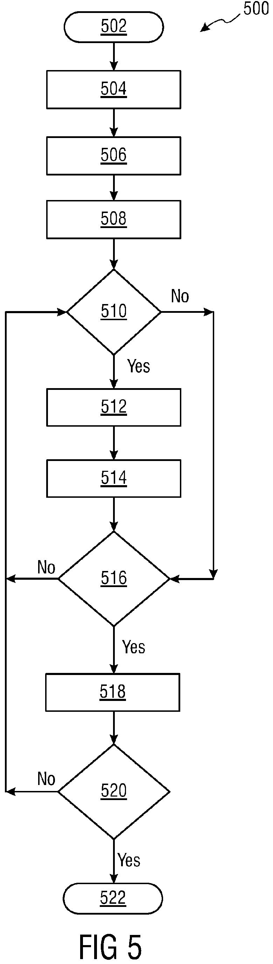

Referring to FIG 5, illustrated is a flowchart of the automatic calibration function (as represented by reference numeral 500), in accordance with one or more embodiments of the present invention. The automatic calibration function 500 provides an algorithm for automatic calibration of the stator earth fault protection for the generator. At block 502, the process 500 starts. At block 504, the process 500 begins with the initialization of variables and configuration parameters to the device from calibration tools such as Digsi. Following this, at block 506, the stator is connected to the grounding terminal (calibration terminal), establishing the necessary physical interface for calibration. Subsequent to the connection, at block 508, the process 500 involves reading the phase angle (φ20) and fault resistance (Rf) values from the Intelligent Electronic Device (IED). These readings are used in the calibration process as they provide the initial data required for calibration evaluation.

At block 510, the process 500 advances to a decision step, where it is determined whether calibration is required based on predefined conditions or threshold levels. If calibration is not necessary, the process 500 halts; otherwise, it continues to the next block 512. If calibration is needed, the process 500 employs a linear regression algorithm to automatically calculate the necessary compensation angle and primary resistance value. The linear regression algorithm utilizes existing data patterns to predict and set the optimal calibration values for the IED. Upon calculating the calibration data, at block 514, the calibrated values are then applied into the lED using calibration tools. This application ensures that settings of the lED reflect the updated calibration values.

Following the application of calibrated data, at block 516, the process 500 involves performing check or validation to ensure the calibration was successful. This may involve verifying that responses of the lED to simulated fault conditions are in line with expected outcomes. If the system checks confirms that calibration is successful, the process 500 moves to block 518 to perform post-calibration checks. This includes setting the pickup (alarm) and trip values in the lED to ensure it responds correctly under fault conditions. Further, the process 500 includes a decision step at block 520. Herein, the process 500 involves evaluating whether the system performance meets the desired criteria post-calibration. If the performance is satisfactory, the calibration process concludes at block 522; if not, additional adjustments and re-calibration may be necessary.

The present invention provides the system 200 and the method 400 for automatic calibration of stator earth fault protection for the generator, which accounts for the dynamic nature of generator systems and the various influencing factors during fault conditions, such as system impedance, fault location, and fault inception angles. The system 200 and the method 400 provides auto calibration to facilitate the regular verification of changes in resistance during fault conditions, streamlining the calibration process for enhanced operational efficacy. It may be appreciated that manual calibration of 100% stator earth fault detection systems can be a time-consuming process, requiring expert knowledge and extensive testing. The system 200, providing auto calibration, significantly reduces the time and effort required for calibration, enabling faster commissioning, maintenance, and troubleshooting activities. Normal time for calibration of 100% earth fault takes min. 4 hours to 8 hours to complete. With the present solution, it can be reduced to less than 5 minutes.

The ability of the system 200 to enhance the accuracy of 100% stator earth fault detection is a significant advancement over the prior art. The system 200 enhances the accuracy of 100% stator earth fault detection. It ensures that the detection system is properly calibrated to accurately identify and detect 100% stator earth faults, minimizing the risk of false positives or false negatives. By automating the calibration process, the system 200 helps maintain the reliability of the 100% stator earth fault detection system. The system 200 continuously monitors the generator operation and adjusts calibration parameters as necessary, ensuring optimal performance and minimizing the likelihood of missed detections or false alarms. The system 200 further ensures that the stator earth fault detection system stays accurate over time, even in the presence of environmental changes or component aging. The system 200 continuously monitors and adjusts calibration parameters as needed, allowing for real-time adaptation, and maintaining optimal performance.

Furthermore, inaccurate, or improperly calibrated stator earth fault detection systems can lead to false alarms, causing unnecessary downtime and maintenance efforts. The present system 200 helps minimize false alarms by maintaining the accuracy of the stator earth fault detection system, reducing the risk of unnecessary interventions. Moreover, automating the calibration process using the present system 200 can lead to cost savings. It reduces the need for manual calibration procedures, specialized equipment, and expert personnel, resulting in lower maintenance costs and increased operational efficiency. In general, accurate detection of 100% stator earth faults is crucial for ensuring the safety of electrical systems and personnel. Auto-calibrated systems minimize the risk of undetected earth faults, helping prevent electrical accidents, equipment damage, and potential hazards. Incorporating such feature will also benefits end users and increase products in market drastically.

While the present invention has been described in detail with reference to certain embodiments, it should be appreciated that the present invention is not limited to those embodiments. In view of the present invention, many modifications and variations may be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope.

### Reference Numerals

| | |
|---|---|
| protection system | 10 |
| computing arrangement | 100 |
| bus | 102 |
| processing unit | 104 |
| memory unit | 106 |
| interface | 108 |
| database | 110 |
| input device | 112 |
| output device | 114 |
| calibration module | 116 |
| system | 200 |
| Intelligent Electronic Device (IED) | 202 |
| grounding terminal | 204 |
| digital potentiometer | 206 |
| calibration function | 300 |
| IED | 302 |
| phase angle value | 302a |
| fault resistance value | 302b |
| corrected phase angle value | 302c |
| corrected fault resistance value | 302d |
| training dataset | 304 |
| linear regression algorithm | 306 |
| hypothesis | 308 |
| training dataset | 310 |
| linear regression algorithm | 312 |
| hypothesis | 314 |
| configuration tools | 316 |
| function 1 | 318 |
| function 2 | 320 |
| function 3 | 322 |
| method | 400 |
| step | 410 |
| step | 420 |
| step | 430 |
| step | 440 |
| step | 450 |
| step | 460 |
| step | 470 |
| automatic calibration function | 500 |
| block | 502 |
| block | 504 |
| block | 506 |
| block | 508 |
| block | 510 |
| block | 512 |
| block | 514 |
| block | 516 |
| block | 518 |
| block | 520 |
| block | 522 |

## Claims

1. A system (200) for automatic calibration of stator earth fault protection for a generator, the system (200) comprising:
an Intelligent Electronic Device IED (202) configured to operate in a first calibration mode and a second calibration mode;
a grounding terminal (204) adapted to connect with the lED (202) when operated in the first calibration mode thereof, the grounding terminal (204) configured to provide a controlled path from the lED (202) to ground;
a digital potentiometer (206) adapted to connect with the lED (202) when operated in the second calibration mode thereof, the digital potentiometer (206) configured to simulate a range of earth fault conditions for the lED (202) under different resistance values; and
a processing unit (104) configured to:
obtain phase angle value and fault resistance value from the lED (202), by operating the lED (202) in the first calibration mode thereof,
determine one or more of a correct phase angle value and a correct fault resistance value for the lED (202) based on deviation of the phase angle value and the fault resistance value, as obtained, from respective expected value, utilizing linear regression algorithm(s),
evaluate the one or more of the correct phase angle value and the correct fault resistance value, as determined, for the lED (202) for the stator earth fault protection under the different resistance values, by operating the lED (202) in the second calibration mode thereof, and
configure the lED (202) with the one or more of the correct phase angle value and the correct fault resistance value if the evaluation for the stator earth fault protection succeeds.

2. The system (200) of claim 1, wherein the processing unit (104) is configured to close a contact between the grounding terminal (204) and the lED (202) to operate the lED (202) in the first calibration mode thereof.

3. The system (200) of claim 2, wherein the processing unit (104) is configured to open the contact between the grounding terminal (204) and the lED (202), and close the contact between the digital potentiometer (206) and the lED (202) to operate the lED (202) in the second calibration mode thereof.

4. The system (200) of claim 1, wherein the processing unit (104) is further configured to determine at least one of a pickup value and a trip value for the lED (202) based on the configuration thereof.

5. The system (200) of claim 1, wherein the processing unit (104) is further configured to initiate calibration of the lED (202) in response to any one of the phase angle value and the fault resistance value deviating from the respective expected value.

6. The system (200) of claim 1, wherein the automatic calibration of the stator earth fault protection for the generator is implemented as part of a standalone application or incorporated into a digital twin of the generator.

7. The system (200) of claim 1 further comprising a communication module (108) configured to communicate calibration results and configuration updates to a user.

8. The system (200) of claim 1, wherein the linear regression algorithm(s), utilized by the processing unit (104), are configured to adjust weighting factors based on historical calibration data of the lED (202) in detecting stator earth faults, for determining the one or more of the correct phase angle value and the correct fault resistance value.

9. A method (400) for automatic calibration of stator earth fault protection for a generator, the method (400) comprising:
operating an Intelligent Electronic Device lED (202) in a first calibration mode by connecting the lED (202) with a grounding terminal (204), the grounding terminal (204) configured to provide a controlled path from the lED (202) to ground;
obtaining phase angle value and fault resistance value from the lED (202), by operating the lED (202) in the first calibration mode thereof;
determining one or more of a correct phase angle value and a correct fault resistance value for the lED (202) based on deviation of the phase angle value and the fault resistance value, as obtained, from respective expected value, using linear regression algorithm(s);
operating the lED (202) in a second calibration mode by connecting the lED (202) with a digital potentiometer (206);
simulating a range of earth fault conditions for the lED (202) under different resistance values using the digital potentiometer (206);
evaluating the one or more of the correct phase angle value and the correct fault resistance value, as determined, for the lED (202) for the stator earth fault protection under the different resistance values, by operating the lED (202) in the second calibration mode thereof, and
configuring the lED (202) with the one or more of the correct phase angle value and the correct fault resistance value if the evaluation for the stator earth fault protection succeeds.

10. A computer-program product having machine-readable instructions stored therein, which when executed by a processing unit (104), cause the processing unit (104) to perform a method (400) according to the claim 9.
